# EUROPEAN PATENT APPLICATION

(11) **EP 4 629 279 A1**
(43) Date of publication of application: **08.10.2025**
(21) Application number: 23897454.7
(22) Date of filing: 13.11.2023
(51) Int. Cl.: H01L 21/02, B23K 26/364, H01L 21/301, H01L 21/304, H01L 25/065, H01L 25/07, H01L 25/18

(54) **METHOD FOR PRODUCING MULTILAYER DEVICE**

(30) Priority: 02.12.2022 JP 2022193280
(71) Applicant: Tazmo Co., Ltd., Okayama-shi, Okayama 701-1221 (JP)
(72) Inventor: YAMABE, Hiroshi, Okayama-shi, Okayama 701-1221 (JP); SANO, Ichiro, Okayama-shi, Okayama 701-1221 (JP)
(74) Representative: Knöner, Gregor
(86) International application number: PCT/JP2023/040688
(87) International publication number: WO 2024/116802

(57) **Abstract**

A method of manufacturing a multilayer device performs a dividing step and a joining step before cutting is performed on a first joining target provided with a plurality of base regions while the first joining target is held by a first support. Here, the cutting is for singulating the base regions individually. In the dividing step, cutting using plasma or laser light is performed on a second joining target provided with a plurality of chip regions while the second joining target is held by a second support to form a dividing part for dividing adjacent ones of the chip regions from each other at a predetermined width therebetween. In the joining step, the second support is moved relative to the first support while the first joining target is held by the first support, thereby joining the second joining target to the first joining target in such a manner that at least one of the chip regions corresponding to each of the base regions is stacked on the corresponding base region in a predetermined positional relationship therebetween.

## Description

### Technical Field

The present invention relates to a technique of manufacturing a multilayer device including a plurality of stacked chips.

### Background Art

In the field of semiconductor technology, various methods such as COW (Chip on Wafer) method and WOW (Wafer on Wafer) method have been suggested as techniques of stacking chips such as LSI(large scale integration) chips three-dimensionally.

According to the COW method (see Patent Literatures 1 and 3, for example), cutting is first performed on a semiconductor wafer to divide the semiconductor wafer into a plurality of individual chips. Next, these chips are stacked one by one on a base wafer. After the chips are stacked to an intended number of stacked layers, cutting is performed on the base wafer to divide the base wafer into a plurality of individual bases (each of which is a part to become a foundation of a multilayer device). As a result, the multilayer device in which the chips are stacked on each other on the base is completed.

According to the WOW method (see Patent Literatures 2 and 3, for example), semiconductor wafers are first stacked on a base wafer. After the semiconductor wafers are stacked to an intended number of stacked layers, cutting is performed on a stack of the wafers to divide the wafer stack into a plurality of individual multilayer devices.

### Citation List

### Patent Literatures

Patent literature 1: Japanese published patent No. 5853754
Patent literature 2: Japanese published patent No. 6391999
Patent literature 3: Japanese published patent No. 6485897

### Summary of Invention

### Technical Problem

However, each of the conventional COW method and the WOW method has a problem of complicating manufacturing processes as described below.

Considering a case where a base wafer is provided with N regions (base regions) each of which is a region to become a base of a multilayer device, it is required to stack chips one by one on the N base regions according to the COW method. This requires stacking operation to be performed N times in stacking chips as a first layer on the base wafer. If chips are to be stacked to an M-th layer on the base wafer, stacking operation is required to be performed N × M times.

If thinned semiconductor wafers are required to be stacked on a base wafer according to the WOW method, it makes handling for the semiconductor wafers technically difficult to try to stack their wafers on the base wafer after thinning them. In response to this, what has conventionally been done is to join (stack) a semiconductor wafer before thinning onto the base wafer and then thin the semiconductor wafer by polishing. Meanwhile, shear stress occurs at a joint surface between wafers during polishing. Hence, if joining strength is low, the joining (stacking) between the wafers is exposed to a risk of break. This has necessitated implementation of a thermal process on a stack as a whole in order to enhance the joining strength before polishing. Hence, to stack thinned semiconductor wafers to an intended number of stacked layers on the base wafer, the thermal process for enhancing the joining strength has been required to be performed before polishing in response to each stacking of the semiconductor wafer in one layer.

Thus, regarding a technique of manufacturing a multilayer device including a plurality of stacked chips, the present invention is intended to simplify a manufacturing process remarkably.

### Solution to Problem

A method of manufacturing a multilayer device according to the present invention performs a dividing step and a joining step before cutting is performed on a first joining target provided with a plurality of base regions while the first joining target is held by a first support. Here, the cutting is for singulating the base regions individually. In the dividing step, cutting using plasma or laser light is performed on a second joining target provided with a plurality of chip regions while the second joining target is held by a second support to form a dividing part for dividing adjacent ones of the chip regions from each other at a predetermined width therebetween, thereby singulating the chip regions individually. In the joining step, the second support is moved relative to the first support while the first joining target is held by the first support, thereby joining the second joining target to the first joining target in such a manner that at least one of the chip regions corresponding to each of the base regions is stacked on the corresponding base region in a predetermined positional relationship therebetween.

Like in the conventional COW method, in the above-described manufacturing method, it is required that, after the individually-singulated chip regions are joined (stacked) onto the base regions, the base regions be singulated individually by performing cutting (not limited to cutting using plasma or laser light) on the first joining target. Thus, in such a manufacturing method, in order to allow implementation of cutting on the first joining target after joining (stacking) of the individually-singulated chip regions, it becomes necessary to generate a reasonable gap (a gap allowing implementation of cutting on the first joining target) between the chip regions adjacent to each other on the first joining target.

Hence, what has been done according to the conventional COW method is to design the size of the chip regions smaller than the size of the base regions before the chip regions are singulated individually by cutting, and then take out the individually-singulated chip regions one by one and join (stack) the chip regions onto the base region, or take out the chip regions one by one and relocate the chip regions on a support (such as a holding sheet) while forming corresponding positional relationships with the base regions in order to allow the chip regions to be joined collectively to the base regions. Thus, such a conventional COW method necessitates taking out the individually-singulated chip regions one by one during joining (stacking) onto the base regions.

Meanwhile, trying to take out the individually-singulated chip regions one by one causes a risk of contact with the adjacent chip region. Moreover, if plasma or laser light was used in cutting for singulating the chip regions individually in the conventional COW method, a cutting line would become extremely thin (equal to or less than 10 µm, for example). This increases a probability of contact with the adjacent chip region if the chip regions are to be taken out one by one while being kept in a state after cutting. In order to avoid such contact, it has been required to increase a distance between the adjacent chip regions by expanding a support (such as a holding sheet) having been used in singulating the chip regions individually if the support is an expandable and contractible sheet, or if not, by transferring the chip regions to an expandable and contractible sheet and thereafter expanding the expandable and contractible sheet. However, increasing the distance between the chip regions by expanding the expandable and contractible sheet causes unevenness in distance between the adjacent chip regions. Hence, in order to grasp the positions of the chip regions on the expandable and contractible sheet, measurement of these positions is additionally required.

According to the above-described manufacturing method, it is possible to generate a reasonable gap between the adjacent chip regions allowing implementation of cutting on the first joining target by adjusting the width of the dividing part (predetermined width) appropriately in the dividing step. Thus, in the joining step, simply by joining the chip regions as they are onto the first joining target after the chip regions are singulated individually in the dividing step, the reasonable gap (the gap allowing implementation of cutting on the first joining target) can also be generated directly between the adjacent chip regions on the first joining target. This allows formation of the reasonable gap between the adjacent chip regions on the first joining target without the need for taking out the chip regions one by one unlike in the conventional case. This eliminates the need for processes such as expansion of an expandable and contractible sheet and position measurement of each of the chip regions after the expansion. Even after being singulated individually, the chip regions can still be handled while being kept in their positional relationships before the singulation (namely, before the dividing step). This eventually facilitates handling of the individually-singulated chip regions.

By providing the chip regions to the second joining target while forming corresponding positional relationships with the base regions, the chip regions singulated individually in the dividing step can be collectively joined onto the base regions provided at the first joining target in the joining step while the chip regions are collectively positioned in such a manner that a positional relationship of each of the chip regions with a corresponding one of the base regions becomes the predetermined positional relationship. Specifically, in the joining step, it is possible for the chip regions singulated individually from the second joining target in the dividing step to be collectively joined to (stacked on) the base regions provided at the first joining target through one joining operation.

By doing so, it becomes possible to simplify the manufacturing processes remarkably compared to a case where the chip regions singulated individually from the second joining target are joined (stacked) one by one to (on) the base regions provided at the first joining target. This will be described more specifically as follows. If the N base regions are provided at the first joining target, if the N chip regions are provided at the second joining target, and if the chip regions are to be joined (stacked) one by one to (on) the N base regions, joining (stacking) is required to be performed N times. By contrast, as the joining is required to be performed only once in the above-described manufacturing method, it is possible to simplify the manufacturing processes remarkably.

The cutting using plasma or laser light allows the second joining target to be cut with high accuracy and realizes cutting while generating practically no force on the second joining target acting in a lateral direction (force acting in a direction along the holding surface of the second support). Thus, in the chip regions singulated individually by the formation of the dividing part, it is possible to reduce unevenness between the chip regions in terms of a positional relationship between a circuit in each of the chip regions and an edge (outer rim) of this chip region. It is further possible to enhance deflective strength of a cutting plane and also possible to form a clean edge free from a defect, etc.

### Advantageous Effects of Invention

According to the present invention, regarding a technique of manufacturing a multilayer device including a plurality of stacked chips, a manufacturing process is simplified remarkably.

### Brief Description of Drawings

FIG. 1 is a perspective view conceptually showing a multilayer device obtained by a manufacturing method according to an embodiment.
FIG. 2A is a plan view showing a base parent material (first joining target), and FIG. 2B is a plan view showing a chip parent material (second joining target).
FIG. 3 is a conceptual view showing states before and after the base parent material (first joining target) is held by a first support.
FIG. 4 is an enlarged perspective view about a part corresponding to a region Ya shown in an upper left view of FIG. 3.
FIG. 5 is a conceptual view showing a dividing step.
FIG. 6 is an enlarged perspective view about a part corresponding to a region Yb shown in an upper left view of FIG. 5.
FIG. 7A is a plan view conceptually showing a state of a second joining target G2 after implementation of the dividing step, and FIG. 7B is a vertical sectional view along a line Za-Za shown in FIG. 7A (the same line as a line Za-Za shown in a lower left view of FIG. 5).
FIGS. 8A to 8C are conceptual views showing a method of forming a dividing part performed in the dividing step according to the embodiment.
FIG. 9A is a conceptual view showing a joining step, and FIG. 9B is a vertical sectional view along a line Zb-Zb shown in an upper left view of FIG. 9A.
FIG. 10A is a conceptual view showing the joining step performed in repetitive processes, and FIG. 10B is a vertical sectional view along a line Zc-Zc shown in FIG. 10A.
FIG. 11A is a conceptual view showing a state where the chip parent materials (second joining targets) are joined (stacked) to a seventh layer on the base parent material (first joining target), and FIG. 11B is a vertical sectional view along a line Zd-Zd shown in FIG. 11A.
FIG. 12 is a vertical sectional view illustrating a state where the chip parent materials (second joining targets) are joined (stacked) to a second layer on the base parent material (first joining target) in a fourth modification.
FIG. 13A to 13C are conceptual views showing processes that can be performed instead of a thinning step and the dividing step.

### Description of Embodiments

### [1] Embodiment

### [1-1] Configuration of Multilayer Device

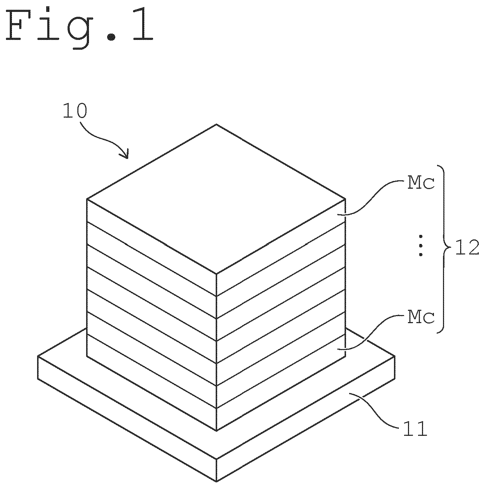

FIG. 1 is a perspective view conceptually showing a multilayer device 10 obtained by a manufacturing method according to an embodiment. As shown in FIG. 1, the multilayer device 10 includes a base 11 and a chip stack 12. Here, the base 11 is a part to become a foundation of the multilayer device 10. The base 11 is provided with an external terminal, an interconnect line, and others. The chip stack 12 is a part composed of a plurality of chips Mc stacked three-dimensionally on the base 11. In the exemplary case shown in FIG. 1, the chips Mc are stacked three-dimensionally from a first layer to a seventh layer on the base 11. While not particularly limited, the chips Mc are semiconductor chips such as LSI chips, for example. The number of stacked layers of the chips Mc may be changed, as appropriate, to the number of stacked layers (including one layer) other than seven layers.

The base 11 may be provided with a circuit same as or different from the chips Mc as well as a terminal or an interconnect line. The chips Mc forming the chip stack 12 may include those having the same circuit or those having different circuits.

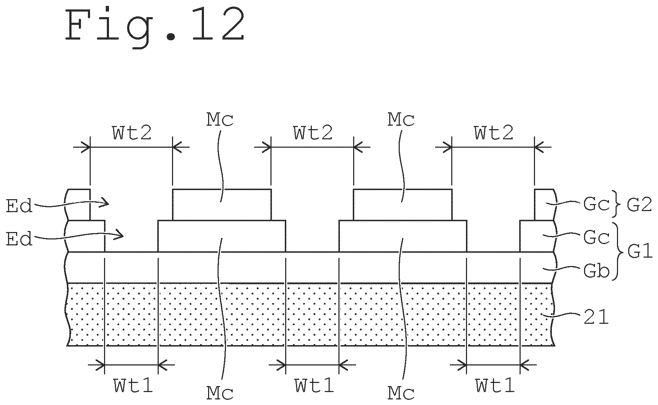

In the present embodiment, all the chips Mc have the same shape that is a rectangular shape (including a square shape) and have the same size. The base 11 has a rectangular shape (including a square shape) and has a larger size than the chips Mc. The shapes and sizes are not limited to these but may be changed, as appropriate. The shapes of the base 11 and the chips Mc may be changed to a circular shape, for example. Like in a fourth modification (see FIG. 12) described later, the chips Mc of different sizes may be stacked on each other on the base 11. Like in a fifth modification described later, the chips Mc may be stacked three-dimensionally in a plurality of places on the base 11.

### [1-2] Method of Manufacturing Multilayer Device

According to the manufacturing method of the present embodiment, a base parent material Gb and a chip parent material Gc are used as parent materials for manufacturing the multilayer device 10. While not particularly limited, these parent materials are semiconductor wafers, for example.

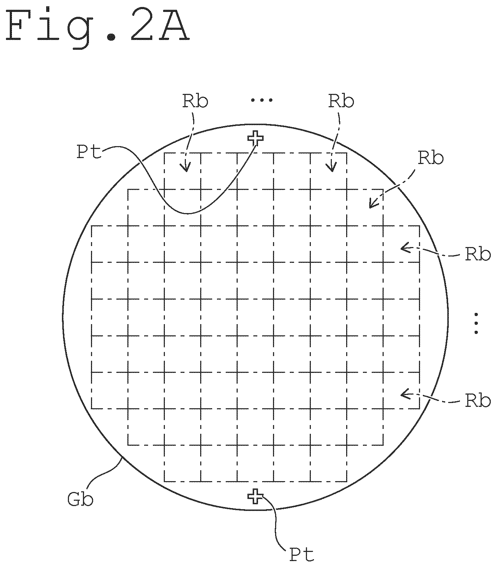

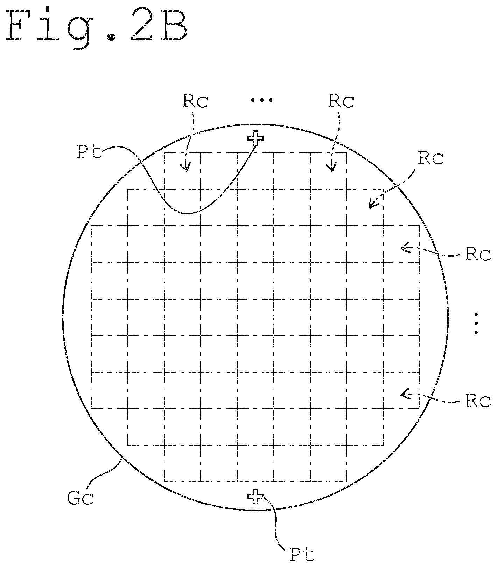

FIGS. 2A and 2B are plan views showing the base parent material Gb and the chip parent material Gc respectively. As shown by alternate long and short dashed lines in FIG. 2A, the base parent material Gb is provided with a plurality of regions (base regions Rb) to become the bases 11. As shown by alternate long and short dashed lines in FIG. 2B, the chip parent material Gc is provided with a plurality of regions (chip regions Rc) to become the chips Mc.

In the present embodiment, equal numbers of the base regions Rb and the chip regions Rc are provided at the base parent material Gb and the chip parent material Gc respectively. These regions are formed in such a manner that each of the chip regions Rc has one-to-one correspondence to each of the base regions Rb, and are formed in such a manner that, when a positional relationship between the base region Rb and the chip region Rc as one set corresponding to each other is adjusted to become a predetermined positional relationship, a positional relationship between the base region Rb and the chip region Rc as any of the other sets also becomes the predetermined positional relationship. Here, the predetermined positional relationship is a positional relationship for causing respective circuits of the base region Rb and the chip region Rc to function normally in the multilayer device 10 (a positional relationship taking a position of connection between the circuits, and others, into consideration).

In the present embodiment, before the base parent material Gb is subjected to cutting for singulating a plurality of the base regions Rb individually, the chip regions Rc (chips Mc) singulated individually by performing cutting on the chip parent material Gc are joined (stacked) three-dimensionally to an intended number of stacked layers on these base regions Rb, as described later in detail. Thus, like in the conventional COW method, in the manufacturing method of the present embodiment, it is required that, after the individually-singulated chip regions Rc are joined (stacked) onto the base regions Rb, the base regions Rb be singulated individually by performing cutting (not limited to cutting using plasma or laser light) on the base parent material Gb. Thus, in such a manufacturing method, in order to allow implementation of cutting on the base parent material Gb after joining (stacking) of the individually-singulated chip regions Rc (chips Mc), it becomes necessary to generate a reasonable gap (a gap allowing implementation of cutting on the base parent material Gb) between the chip regions Rc (chips Mc) adjacent to each other on the base parent material Gb.

Hence, what has been done according to the conventional COW method is to design the size of the chip regions Rc smaller than the size of the base regions Rb before the chip regions Rc are singulated individually by cutting on the chip parent material Gc, and then take out the individually-singulated chip regions Rc one by one and join (stack) the chip regions Rc onto the base region Rb, or take out the chip regions Rc one by one and relocate the chip regions Rc on a support (such as a holding sheet) while forming corresponding positional relationships with the base regions Rb in order to allow the chip regions Rc to be joined collectively to the base regions Rb. Thus, such conventional COW method necessitates taking out the individually-singulated chip regions Rc one by one during joining (stacking) onto the base regions Rb.

Meanwhile, trying to take out the individually-singulated chip regions Rc one by one causes a risk of contact with the adjacent chip region Rc. Moreover, if plasma or laser light was used in cutting for singulating the chip regions Rc individually in the conventional COW method, a cutting line would become extremely thin (equal to or less than 10 µm, for example). This increases a probability of contact with the adjacent chip region Rc if the chip regions Rc are to be taken out one by one while being kept in a state after cutting. In order to avoid such contact, it has been required to increase a distance between the adjacent chip regions Rc by expanding a support (such as a holding sheet) having been used in singulating the chip regions Rc individually if the support is an expandable and contractible sheet, or if not, by transferring the chip regions Rc to an expandable and contractible sheet and thereafter expanding the expandable and contractible sheet. However, increasing the distance between the chip regions Rc by expanding the expandable and contractible sheet causes unevenness in distance between the adjacent chip regions Rc. Hence, in order to grasp the positions of the chip regions Rc on the expandable and contractible sheet, measurement of these positions is additionally required.

In manufacturing processes for manufacturing the multilayer device 10, the present embodiment facilitates handling of the individually-singulated chip regions Rc, thereby simplifying the manufacturing processes remarkably. As processes for such simplification, a thinning step, a dividing step, a joining step, and a cutting step are performed. The following describes a flow of the manufacturing processes and particulars of each of the steps in detail. These steps can be performed using various types of well-known devices. The manufacturing method described below is further applicable to a case where, in the multilayer device 10 to be manufactured, the number of stacked layers of the chips Mc is other than seven layers (including one layer).

First, one base parent material Gb and one chip parent material Gc are prepared. Using these two parent materials as targets, the thinning step, the dividing step, and the joining step are performed. Here, the base parent material Gb and the chip parent material Gc are called a "first joining target G1" and a "second joining target G2" respectively.

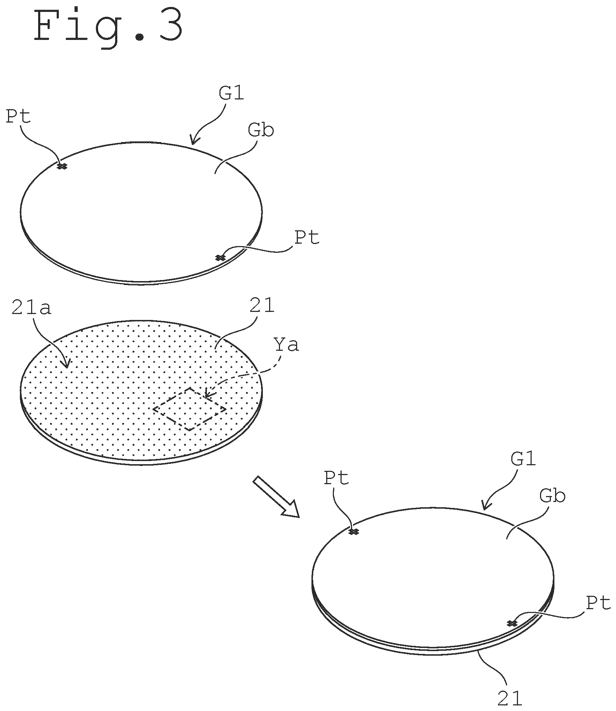

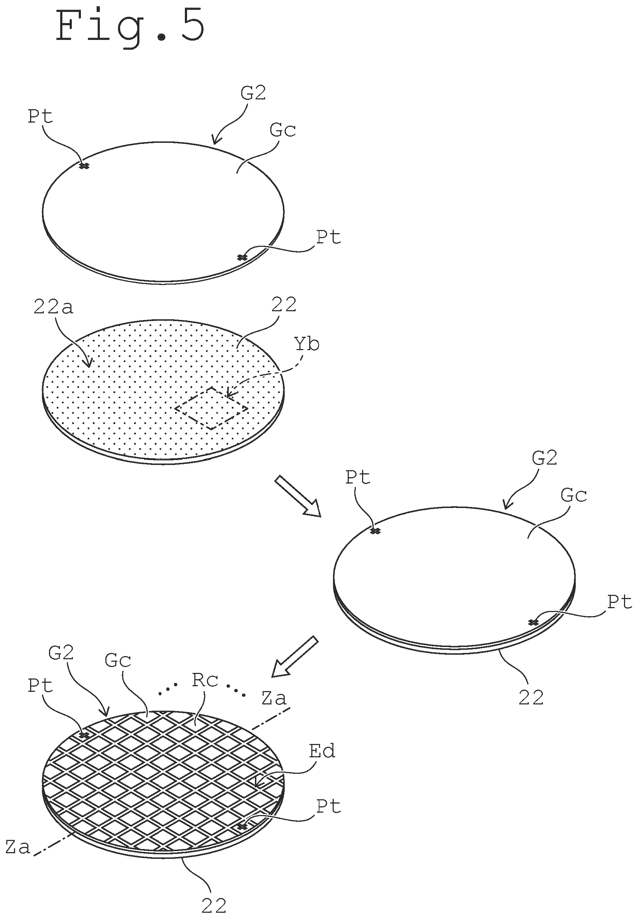

Then, the first joining target G1 (base parent material Gb) is held by a first support 21 (upper left view and right view of FIG. 3). In the present embodiment, the first support 21 is a holding sheet containing resin (such as polyolefin or silicone) or rubber (such as fluoride rubber) having at least an attractive force as a main component thereof, and can hold the first joining target G1 using the attractive force of the main component. The first support 21 further has a configuration as below. The second joining target G2 (chip parent material Gc) is held by a second support 22 in the dividing step described later (see upper left view and right view of FIG. 5).

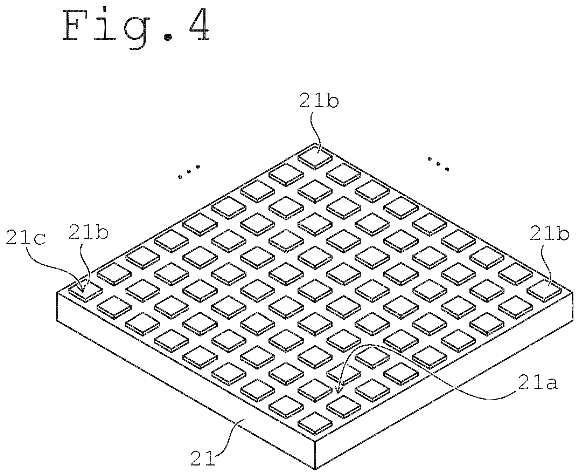

FIG. 4 is an enlarged perspective view about a part corresponding to a region Ya of the first support 21 (holding sheet) shown in the upper left view of FIG. 3. As shown in this drawing, the first support 21 is provided with a plurality of projections 21b formed on a holding surface 21a for holding the first joining target G1. The projections 21b are made of a component same as the main component forming the first support 21 and are formed integrally with the first support 21. By bringing the first joining target G1 into surface-contact with the projections 21b, the first joining target G1 is held by the first support 21 using attractive forces of the projections 21b.

Meanwhile, when the first joining target G1 is held on the holding surface 21a, the first joining target G1 comes into surface-contact with the holding surface 21a only in parts where the projections 21b are provided. In the example of FIG. 4, the projections 21b are each formed in such a manner that a contact surface 21c thereof to come into contact with the first joining target G1 has a rectangular shape (including a square shape). As long as the contact surface 21c of the projection 21b allows the first joining target G1 to be held thereon, the shape thereof is not limited to a rectangular shape but may be changed to various shapes including a polygonal shape and a circular shape, as appropriate.

According to the first support 21 described above, it is possible to adjust an area of contact with the first joining target G1 by setting the number of the projections 21b or the area of the contact surface 21c. This eventually makes it possible to adjust the force of the first support 21 for holding the first joining target G1 (namely, a total sum of the attractive forces of the projections 21b). By adjusting the holding force of the first support 21, it becomes possible to maintain the holding force required for the manufacturing processes and facilitate pickup of the multilayer device 10 accompanying peeling thereof from the first support 21 after the multilayer device 10 is completed in the cutting step described later. More specifically, it is possible to adjust the holding force of the first support 21 at an appropriate degree so as not to break a joint part in the multilayer device 10 during peeling of the multilayer device 10 from the first support 21 though the pickup. As a result, by holding the first joining target G1 using the described first support 21, it becomes possible to hold the first joining target G1 firmly and facilitate peeling of the multilayer device 10 from the first support 21 without causing adverse effect (such as break) on the joint part in the multilayer device 10 and others when the peeling becomes necessary.

The first support 21 may be changed to a support prepared by forming the above-described holding sheet on a surface of any type of substrate (such as a wafer or a glass substrate), as appropriate. As an example, the holding sheet with the projections 21b can be formed on the surface of the substrate by applying resin or rubber having an attractive force to the surface of the substrate and thereafter molding the resin or the rubber by embossing or the like. As long as the first support 21 allows peeling of the multilayer device 10 therefrom, the first support 21 may be changed, as appropriate, to a substrate (such as a wafer or a glass substrate) by which the first joining target G1 is held with adhesive agent, for example.

### <Thinning Step>

In the thinning step, the second joining target G2 (chip parent material Gc) is thinned by being subjected to polishing. As an example, the second joining target G2 is thinned to a thickness of equal to or less than 150 µm. In the present embodiment, the second joining target G2 is thinned before the dividing step (namely, before the joining step) described later.

In the thinning step, in addition to thinning the second joining target G2, the first joining target G1 (base parent material Gb) may be thinned to an intended thickness (this thickness may differ from that of the second joining target G2). If the first joining target G1 is thinned, the first joining target G1 may be held by the first support 21 after thinning of the first joining target G1. As described above, it is possible for the first support 21 to hold the first joining target G1 firmly and facilitate peeling without causing adverse effect (such as break) on the joint part and others when the peeling becomes necessary. Thus, even the thinned first joining target G1 can still be handled easily by holding the first joining target G1 using the described first support 21.

In the present embodiment, in both cases where the base parent material Gb is thinned and where the chip parent material Gc is thinned, they are thinned before joining (stacking) in the joining step described later. Here, if the base parent material Gb or the chip parent material Gc is intended to be thinned after the joining (stacking) like in the conventional case, shear stress occurs at a joint surface between the parent materials during polishing. As a result, if joining strength is low, the joining (stacking) between the parent materials is exposed to a risk of break. Hence, in order to realize thinning by the conventional method, it is necessary to enhance the joining strength by performing a thermal process on a stack as a whole before polishing. If two or more chip parent materials Gc are to be joined to (stacked on) each other on the base parent material Gb, joining (stacking) is required to be performed twice or more and the thermal process for enhancing the joining strength is required to be performed before polishing in response to each joining. On the other hand, performing the above-described thinning step before joining (stacking) like in the present embodiment eliminates the need for performing the thermal process in response to each joining, thereby simplifying the manufacturing processes.

### <Dividing Step>

FIG. 5 is a conceptual view showing the dividing step. In the dividing step, the second joining target G2 (chip parent material Gc) thinned in the thinning step is held by the second support 22 (upper left view and right view of FIG. 5). In the present embodiment, like the first support 21, the second support 22 is a holding sheet containing resin (such as polyolefin or silicone) or rubber (such as fluoride rubber) having at least an attractive force as a main component thereof, and can hold the second joining target G2 using the attractive force of the main component. The second support 22 further has a configuration as follows.

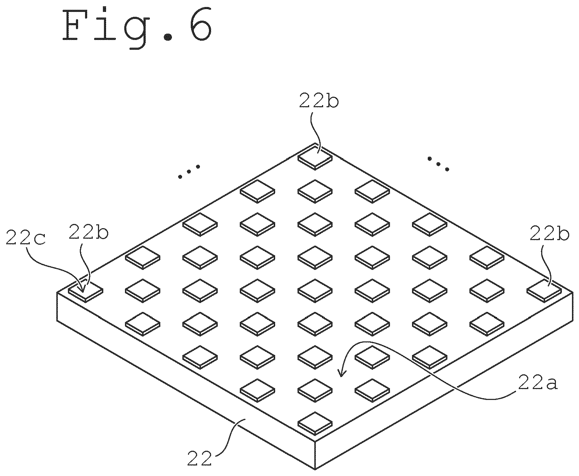

FIG. 6 is an enlarged perspective view about a part corresponding to a region Yb of the second support 22 (holding sheet) shown in the upper left view of FIG. 5. As shown in this drawing, the second support 22 is provided with a plurality of projections 22b formed on a holding surface 22a for holding the second joining target G2. The projections 22b are made of a component same as the main component forming the second support 22 and are formed integrally with the second support 22. By bringing the second joining target G2 into surface-contact with the projections 22b, the second joining target G2 is held by the second support 22 using attractive forces of the projections 22b.

Meanwhile, when the second joining target G2 is held on the holding surface 22a, the second joining target G2 comes into surface-contact with the holding surface 22a only in parts where the projections 22b are provided. In the example of FIG. 6, the projections 22b are each formed in such a manner that a contact surface 22c thereof to come into contact with the second joining target G2 has a rectangular shape (including a square shape). As long as the contact surface 22c of the projection 22b allows the second joining target G2 to be held thereon, the shape thereof is not limited to a rectangular shape but may be changed to various shapes including a polygonal shape and a circular shape, as appropriate.

According to the second support 22 described above, it is possible to adjust an area of contact with the second joining target G2 by setting the number of the projections 22b or the area of the contact surface 22c. This eventually makes it possible to adjust the force of the second support 22 for holding the second joining target G2 (namely, a total sum of the attractive forces of the projections 22b). By adjusting the holding force of the second support 22, it becomes possible to maintain the holding force required for the manufacturing processes and facilitate peeling of the second support 22 from the second joining target G2 after the second joining target G2 is joined to (stacked on) the first joining target G1 in the joining step described later. More specifically, it is possible to adjust the holding force of the second support 22 at an appropriate degree so as not to break the joint part during peeling of the second support 22 from the second joining target G2. As a result, by holding the second joining target G2 using the described second support 22, it becomes possible to hold the second joining target G2 firmly and facilitate peeling of the second support 22 from the second joining target G2 without causing adverse effect (such as break) on the joint part between the parent materials and others when the peeling becomes necessary. Thus, even the thinned second joining target G2 can still be handled easily.

The second support 22 may be changed to a support prepared by forming the above-described holding sheet on a surface of any type of substrate (such as a wafer or a glass substrate), as appropriate. As an example, the holding sheet with the projections 22b can be formed on the surface of the substrate by applying resin or rubber having an attractive force to the surface of the substrate and thereafter molding the resin or the rubber by embossing or the like. As long as the second support 22 can be peeled from the second joining target G2, the second support 22 may be changed, as appropriate, to a substrate (such as a wafer or a glass substrate) by which the second joining target G2 is held with adhesive agent, for example.

Furthermore, in the present embodiment, the respective holding surfaces 21a and 22a of the first support 21 and the second support 22 (see FIGS. 4 and 6) are provided with the projections 21b and 22b respectively in such a manner that an area of contact between the second support 22 and the second joining target G2 determined when the second joining target G2 is held by the second support 22 becomes smaller than an area of contact between the first support 21 and the first joining target G1 determined when the first joining target G1 is held by the first support 21. In this configuration, a difference in size is made between the contact areas to generate a difference in holding force. As a result, it becomes possible to generate a difference in peel strength (more specifically, peeling is facilitated further as a contact area becomes smaller). Thus, when only the second support 22 is to be peeled after the second joining target G2 is joined to (stacked on) the first joining target G1 in the joining step described later, it is possible to peel only the second support 22 easily by taking advantage of the above difference in holding force (here, the difference in peel strength).

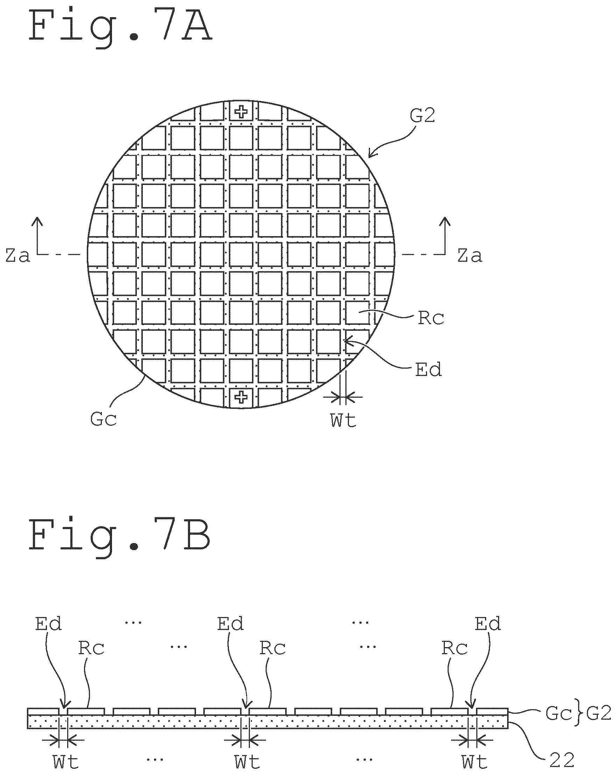

In the dividing step, after the second joining target G2 is held by the second support 22, the second joining target G2 is subjected to cutting in this state using plasma or laser light to form a dividing part Ed for dividing the adjacent chip regions Rc from each other at a predetermined width Wt therebetween, thereby singulating the chip regions Rc individually (see lower left view of FIG. 5, and FIGS. 7A and 7B). A method of forming the dividing part Ed will be described below in detail.

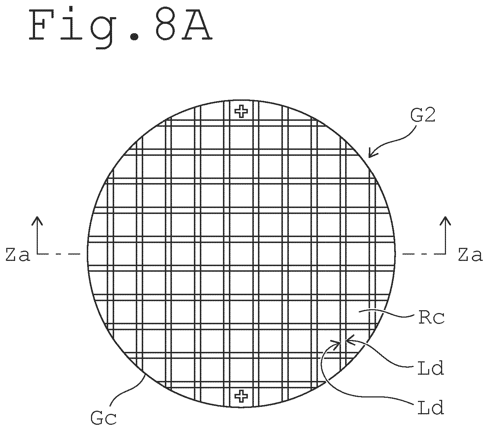

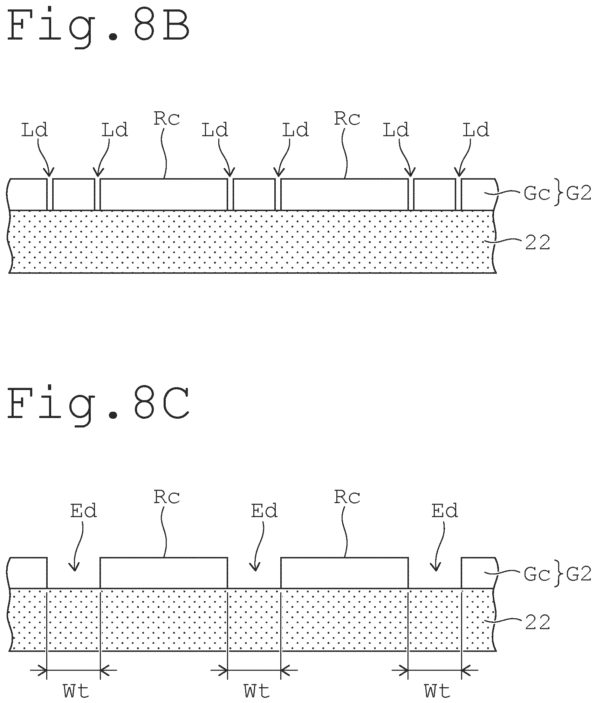

FIGS. 8A to 8C are conceptual views showing the method of forming the dividing part Ed according to the present embodiment. Here, FIG. 8A is a conceptual view showing the second joining target G2 in a plan view like FIG. 7A, and FIG. 8B is a partially-enlarged view showing a part of a vertical section in an enlarged manner along a line Za-Za in FIG. 8A (the same line as a line Za-Za in the lower left view of FIG. 5). FIG. 8C is a conceptual view showing the same part as FIG. 8B and showing a state where the dividing part Ed is completed.

In the present embodiment, as shown in FIGS. 8A and 8B, cutting is performed first using plasma or laser light to form two cutting lines Ld parallel to each other in the second joining target G2. More specifically, the cutting lines Ld are formed by etching cutting sites (forming sites of the cutting lines Ld) using plasma (plasma etching). In doing this, a surface of the second joining target G2 in a region other than the cutting sites is protected from the plasma by a resist. Alternatively, instead of the plasma etching, ablation may be generated at the cutting sites using laser light (laser ablation) to form the cutting lines Ld.

Next, as shown in FIG. 8C, an unnecessary part between the two cutting lines Ld is removed to complete the dividing part Ed. As an example, only the unnecessary part between the two cutting lines Ld can be dropped and removed by turning the second support 22 upside down. As another example, in a cleaning process for removing the resist used in the plasma etching, the unnecessary part between the two cutting lines Ld may be washed away together with the resist to be removed.

According to the above-described method of forming the dividing part Ed, only the forming sites of the cutting lines Ld to become edges of the dividing part Ed require to be cut using plasma or laser light (more specifically, plasma etching or laser ablation). This allows the dividing part Ed to be formed in a shorter time than in a case where plasma etching or laser ablation is performed on an entire forming region of the dividing part Ed.

Furthermore, by adjusting a width between the two cutting lines Ld, it becomes possible to appropriately adjust the width of the dividing part Ed to be formed (predetermined width Wt). By adjusting the width of the dividing part Ed appropriately, it becomes possible to generate a reasonable gap between the adjacent chip regions Rc allowing implementation of cutting on the first joining target G1.

The cutting using plasma or laser light allows the second joining target G2 to be cut with high accuracy and realizes cutting while generating practically no force on the second joining target G2 acting in a lateral direction (force acting in a direction along the holding surface 22a of the second support 22). Thus, in the chip regions Rc singulated individually by the formation of the dividing part Ed, it is possible to reduce unevenness between the chip regions Rc in terms of a positional relationship between a circuit in each of the chip regions Rc and an edge (outer rim) of this chip region Rc. It is further possible to enhance deflective strength of a cutting plane and also possible to form a clean edge free from a defect, etc.

### <Joining Step>

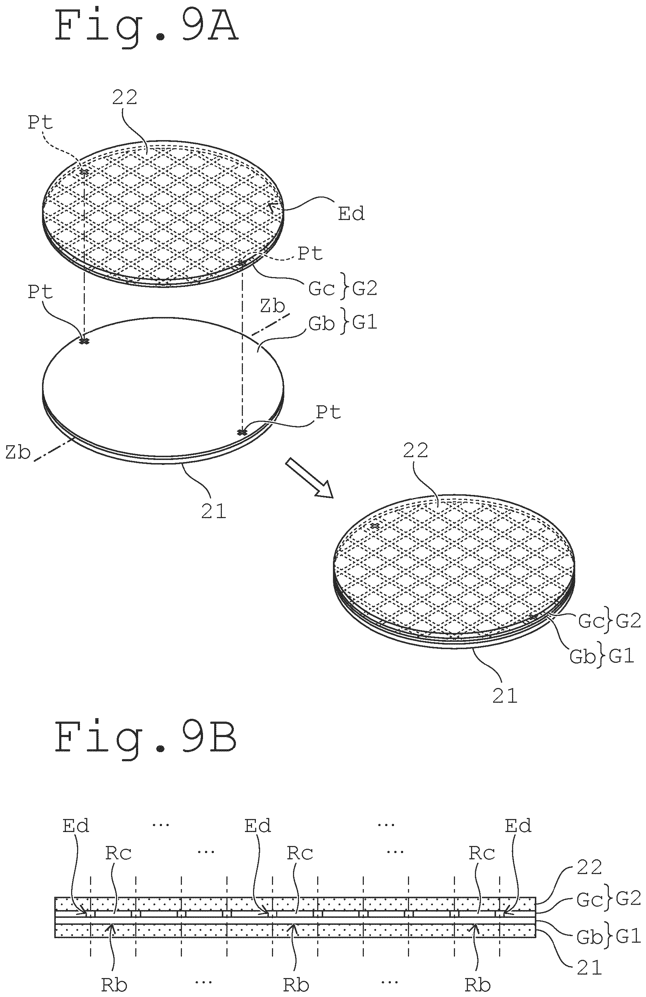

The joining step is performed after the dividing step and after the first joining target G1 is held by the first support 21. FIG. 9A is a conceptual view showing the joining step, and FIG. 9B is a vertical sectional view along a line Zb-Zb shown in an upper left view of FIG. 9A. As shown in FIG. 9A, in the joining step, the second support 22 is moved relative to the first support 21 to join the second joining target G2 to the first joining target G1. More specifically, as shown in FIG. 9B, the second joining target G2 is joined to the first joining target G1 in such a manner that the chip region Rc corresponding to each of the base regions Rb is stacked on the corresponding base region Rb in a predetermined positional relationship therebetween. Here, the predetermined positional relationship is a positional relationship for causing respective circuits of the base region Rb and the chip region Rc to function normally in the multilayer device 10 (a positional relationship taking a position of connection between the circuits, and others, into consideration).

As described above, in the present embodiment, the base regions Rb and the chip regions Rc are formed in such a manner that each of the chip regions Rc has one-to-one correspondence to each of the base regions Rb, and are formed in such a manner that, when a positional relationship between the base region Rb and the chip region Rc as one set corresponding to each other is adjusted to become the predetermined positional relationship, a positional relationship between the base region Rb and the chip region Rc as any of the other sets becomes the predetermined positional relationship. Thus, in the joining step, the chip regions Rc singulated individually in the dividing step can be collectively positioned in such a manner that a positional relationship of each of the chip regions Rc with a corresponding one of the base regions Rb provided at the first joining target G1 becomes the predetermined positional relationship. In the present embodiment, positioning marks Pt (see FIG. 9A) provided at each of the first joining target G1 and the second joining target G2 are used as means for such positioning. A combination between the shape of the positioning marks Pt at the first joining target G1 and the shape of the positioning marks Pt at the second joining target G2 may be a combination between cross shapes as shown in FIG. 9A or a combination between different shapes such as a cross shape and a quadrangular shape.

In the dividing step described above, it is possible to generate a reasonable gap between the adjacent chip regions Rc allowing implementation of cutting on the first joining target G1 by adjusting the width of the dividing part Ed appropriately. Thus, in the joining step, simply by joining the chip regions Rc as they are onto the first joining target G1 after the chip regions Rc are singulated individually in the dividing step, the reasonable gap (the gap allowing implementation of cutting on the first joining target G1) can also be generated directly between the adjacent chip regions Rc on the first joining target G1. This allows formation of the reasonable gap between the adjacent chip regions Rc on the first joining target G1 without the need for taking out the chip regions Rc one by one unlike in the conventional case. This eliminates the need for processes such as expansion of an expandable and contractible sheet and position measurement of each of the chip regions Rc after the expansion. Even after being singulated individually, the chip regions Rc can still be handled while being kept in their positional relationships before the singulation (namely, before the dividing step). This eventually facilitates handling of the individually-singulated chip regions Rc.

Thus, in the joining step, the chip regions Rc singulated individually in the dividing step can be collectively joined onto the base regions Rb provided at the first joining target G1 while the chip regions Rc are collectively positioned in such a manner that a positional relationship of each of the chip regions Rc with a corresponding one of the base regions Rb becomes the predetermined positional relationship. Specifically, in the joining step, it is possible for the chip regions Rc singulated individually from the second joining target G2 in the dividing step to be collectively joined to (stacked on) the base regions Rb provided at the first joining target G1 through one joining operation.

By doing so, it becomes possible to simplify the manufacturing processes remarkably compared to a case where the chip regions singulated individually from the second joining target G2 are joined (stacked) one by one to (on) the base regions Rb provided at the first joining target G1. This will be described more specifically as follows. If the N base regions Rb are provided at the first joining target G1, if the N chip regions Rc are provided at the second joining target G2, and if the chip regions Rc are to be joined (stacked) one by one to (on) the N base regions Rb, joining (stacking) is required to be performed N times. By contrast, as the joining is required to be performed only once in the above-described manufacturing method, it is possible to simplify the manufacturing processes remarkably.

The cutting in the dividing step using plasma or laser light allows cutting with high accuracy. As a result, in the chip regions Rc singulated individually by the formation of the dividing part Ed, it is possible to reduce unevenness between the chip regions Rc in terms of a positional relationship between a circuit in each of the chip regions Rc and an edge (outer rim) of this chip region Rc. Thus, during joining (stacking) between the base region Rb and the chip region Rc in the joining step, as a basis for positioning provided at the second joining target G2, the edge of the chip region Rc may be used instead of the positioning mark Pt.

### <Repetition from Thinning Step to Joining Step>

If the chips Mc are to be stacked in two or more layers on the base 11 in the multilayer device 10 to be manufactured like in the present embodiment (see FIG. 1), two or more chip parent materials Gc are required to be joined to the base parent material Gb. In this case, before moving to the cutting step described later, the above-described thinning step, dividing step, and joining step are performed repeatedly in response to the number of the chip parent materials Gc to be joined to the base parent material Gb. Specifically, in the present embodiment, before the base parent material Gb (first joining target G1) provided with the base regions Rb is subjected to cutting for singulating these base regions Rb individually (before implementation of the cutting step described later), the above-described thinning step, dividing step, and joining step are performed repeatedly to stack the chip Mc (chip region Rc) on each of the base regions Rb provided at the base parent material Gb. The repetitive processes from the thinning step to the joining step will be described below in detail.

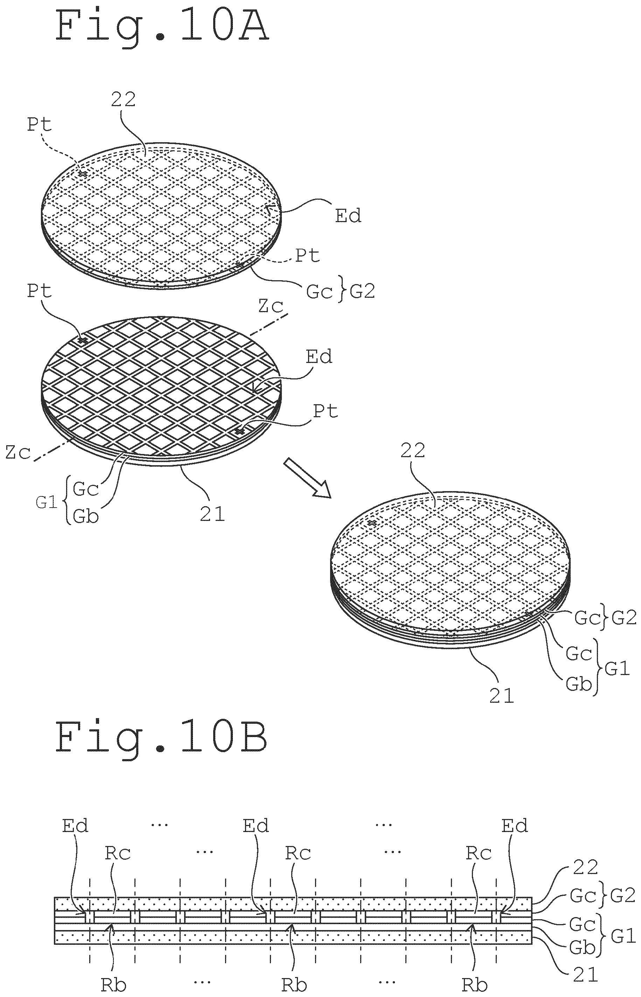

After the above-described joining step, the second support 22 is peeled from the second joining target G2 (see an upper left view of FIG 10A). In the present embodiment, as described above, the holding force of the second support 22 is adjusted at a degree that does not cause break of the joint part between the first joining target G1 and the second joining target G2 during peeling of this sheet. Thus, practically no break resulting from peeling of the second support 22 occurs at the joint part. Furthermore, the respective holding surfaces 21a and 22a of the first support 21 and the second support 22 are provided with the projections 21b and 22b respectively in such a manner that an area of contact between the second support 22 and the second joining target G2 determined when the second joining target G2 is held by the second support 22 becomes smaller than an area of contact between the first support 21 and the first joining target G1 determined when the first joining target G1 is held by the first support 21. This generates a difference in holding force for holding the joining targets between the first support 21 and the second support 22 to eventually generate a difference in peel strength therebetween (more specifically, the second support 22 having a smaller contact area is peeled more easily). Thus, in the present embodiment, it is possible to peel only the second support 22 easily by taking advantage of the difference in holding force (here, the difference in peel strength).

A different chip parent material Gc is thereafter joined further onto the second joining target G2. More specifically, the first joining target G1 to which the second joining target G2 is joined in the above-described joining step (see FIGS. 9A and 9B) is used as a new first joining target G1 and the different chip parent material Gc is used as a new second joining target G2, and then thinning of this second joining target G2, the dividing step (see FIGS. 5, 7A and 7B), and the joining step (see FIGS. 10A and 10B) are further performed.

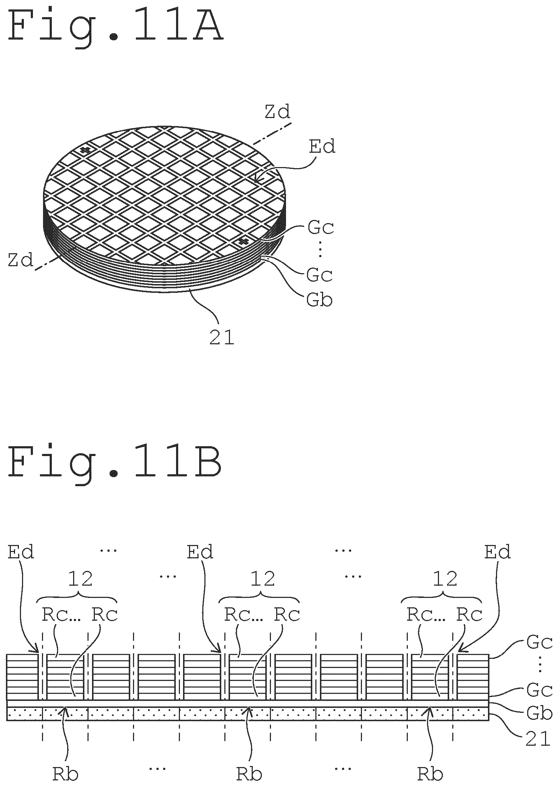

Then, peeling of the second support 22, thinning of the second joining target G2, the dividing step (see FIG. 5), and the joining step (see FIG. 10A) are performed repeatedly in response to the number of the chip parent materials Gc to be joined. In the present embodiment, the seven chip parent materials Gc are required to be joined. Thus, for joining the chip parent materials Gc from a second layer to a seventh layer further after performing the first-time joining step (see FIG. 9A), the above-described repetition is made six times. FIG. 11A is a conceptual view showing a state where the chip parent materials Gc are joined (stacked) to the seventh layer on the base parent material Gb, and FIG. 11B is a vertical sectional view along a line Zd-Zd shown in FIG. 11A.

In the joining step performed in the repetitive processes, as a basis for positioning of a new second joining target G2 with respect to a new first joining target G1, an edge of the chip region Rc belonging to the new first joining target G1 and an edge of the chip region Rc belonging to the new second joining target G2 to be stacked on the former chip region Rc may be used instead of the positioning marks Pt.

According to these repetitive processes, even if the chip parent materials Gc as the second joining targets G2 are to be joined to (stacked on) the first joining target G1 (base parent material Gb) several times, it is still possible for all the chip regions Rc provided at each of the chip parent materials Gc to be joined (stacked) collectively through one joining operation performed on each chip parent material Gc. This will be described more specifically as follows. If the N base regions Rb are provided at the first joining target G1 (base parent material Gb), if the N chip regions Rc are provided at the second joining target G2 (chip parent materials Gc), and if the chip regions Rc are to be stacked one by one and M times three-dimensionally on the N base regions Rb, stacking operation is required to be performed N × M times. By contrast, as performing the joining M times is enough according to the above-described repetitive processes, it is possible to simplify the processes of manufacturing the multilayer device 10 remarkably.

As shown in FIG. 11B, by performing the above repetitive processes, the chip regions Rc (chips Mc) from the first layer to the seventh layer are stacked three-dimensionally on each base region Rb provided at the base parent material Gb, thereby forming the chip stack 12. Furthermore, the reasonable gap (specifically, the gap allowing implementation of cutting on the base parent material Gb) resulting from the dividing part Ed is formed between the adjacent chip stacks 12.

### <Cutting Step>

In the cutting process, cutting is performed on the base parent material Gb by taking advantage of the gap formed between the chip stacks 12 (in the example of FIG. 11B, the base parent material Gb is cut at positions of alternate long and short dashed lines), thereby singulating the base regions Rb individually. As a result, the multilayer device 10 (see FIG. 1) is completed.

### [2] Modifications

### [2-1] First Modification

In the above-described method of manufacturing the multilayer device 10, in the dividing step, the two cutting lines Ld may be formed in such a manner as to locate a PCM (process control monitor) between these two cutting lines Ld. Alternatively, the PCM may be provided in such a manner as to be located between the two cutting lines Ld formed in the dividing step.

According to the configuration of the first modification, in removing the unnecessary part between the two cutting lines Ld, the PCM (more specifically, a circuit element forming the PCM) can be removed together. This eliminates the need for providing an additional process for removing the PCM beforehand (such as removal by means of laser light irradiation), making it possible to simplify the processes of manufacturing the multilayer device 10.

### [2-2] Second Modification

In the above-described method of manufacturing the multilayer device 10, in the dividing step, an etched region etched with plasma and having the predetermined width Wt may be formed as the dividing part Ed by performing plasma etching on an entire forming region of the dividing part Ed.

### [2-3] Third Modification

The above-described method of manufacturing the multilayer device 10 may further perform an inspecting step and a replacing step. Here, the inspecting step and the replacing step are performed after the dividing step and before the joining step. In the inspecting step, each of the chip regions Rc singulated individually in the dividing step is subjected to inspection to determine whether the inspected chip region Rc is a defective item. If a defective item is detected in the inspecting step, the detected defective item is replaced with a good item in the replacing step.

As explained in the above embodiment, in the dividing step, the chip regions Rc provided at the chip parent material Gc are singulated individually while the reasonable gap is provided between the adjacent chip regions Rc. Thus, only one chip region Rc can be taken out easily from the chip regions Rc singulated individually in the dividing step while these chip regions Rc are maintained as they are (specifically, without increasing a distance between the adjacent chip regions Rc using an expandable and contractible sheet or the like) and further while the above one chip region Rc to be taken out is prevented from contacting the adjacent chip region Rc. In the configuration of the third modification, this is used to replace the defective item with the good item, making it possible to enhance a yield (a ratio of good items) of the multilayer devices 10.

### [2-4] Fourth Modification

In the above-described method of manufacturing the multilayer device 10, the multilayer device 10 to be manufactured may be changed, as appropriate, to a device including the chips Mc of different sizes stacked on each other on the base 11. In this case, during joining (stacking) of the chip parent materials Gc (second joining targets G2) of the layers from the second layer in the repetitive processes, the chips Mc formed into different sizes can be stacked by appropriately changing the width of the dividing part Ed (predetermined width Wt) between the layers to be formed at each of these chip parent materials Gc in the dividing step.

FIG. 12 is a vertical sectional view conceptually illustrating a state where the chip parent materials Gc (second joining targets G2) are joined (stacked) to the second layer on the base parent material Gb (first joining target G1) in the fourth modification. In the exemplary case shown in FIG. 12, in order for the size of the chips Mc (individually-singulated chip regions Rc) obtained from the chip parent material Gc in the second layer to become smaller than the size of the chips Mc (individually-singulated chip regions Rc) obtained from the chip parent material Gc in the first layer, the width of the dividing part Ed (predetermined width Wt = Wt2) formed at the chip parent material Gc in the second layer is set larger than the width of the dividing part Ed (predetermined width Wt = Wt1) formed at the chip parent material Gc in the first layer.

### [2-5] Fifth Modification

In the above-described method of manufacturing the multilayer device 10, the multilayer device 10 to be manufactured is not limited to a device where the chips Mc are stacked three-dimensionally only in one place on the base 11 (see FIG. 1) but may be changed, as appropriate, to a device where the chips Mc are stacked three-dimensionally in a plurality of places on the base 11. In this case, the base regions Rb provided at the base parent material Gb (first joining target G1) and the chip regions Rc provided at the chip parent material Gc (second joining target G2) are formed in such a manner that the chip regions Rc in units of two or more correspond to each of the base regions Rb in a predetermined positional relationship therebetween.

### [2-6] Sixth Modification

In the above-described method of manufacturing the multilayer device 10, in the dividing step, the second joining target G2 (chip parent material Gc) thinned in the thinning step may be held by any type of substrate (such as a wafer or a glass substrate), and in this state, the dividing part Ed may be formed using plasma or laser light. After formation of the dividing part Ed and before moving to the joining step to be performed next, the chip regions Rc singulated individually by the formation of the dividing part Ed may be transferred as they are from the substrate to the second support 22.

### [2-7] Seventh Modification

In the above-described method of manufacturing the multilayer device 10, the second joining target G2 (chip parent material Gc) may be thinned and the dividing part Ed may be formed by the following process instead of the thinning step and the dividing step described above.

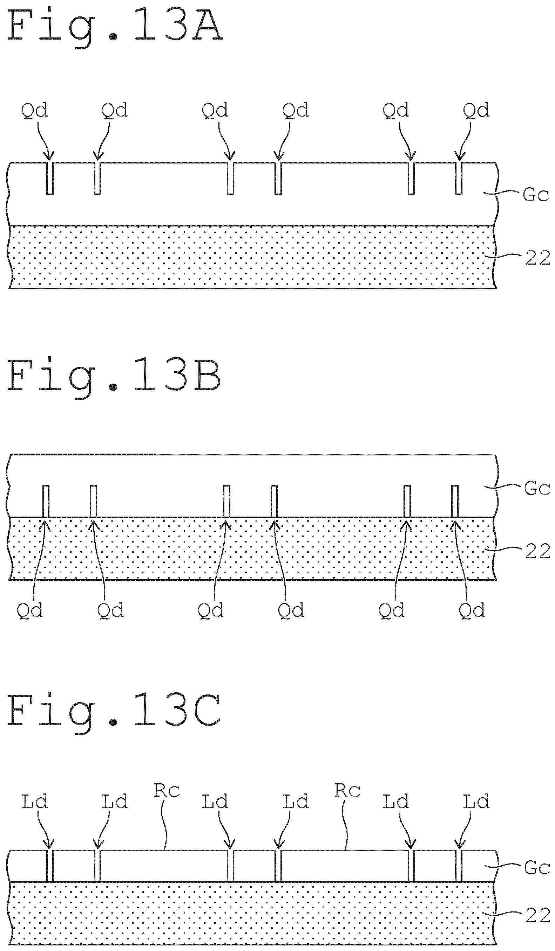

FIGS. 13A to 13C are conceptual views showing processes that can be performed instead of the thinning step and the dividing step described above. As shown in FIG. 13A, before thinning of the second joining target G2 (chip parent material Gc), the second joining target G2 is subjected to cutting using plasma or laser light, thereby forming grooves Qd to become the two cutting lines Ld for forming the dividing part Ed into a depth where the grooves Qd are to be exposed by the thinning. Next, as shown in FIG. 13B, the second joining target G2 is transferred to any type of substrate or holding sheet, and thereafter the transferred second joining target G2 is thinned from a surface on a side opposite to a surface where the grooves Qd are formed. Then, as shown in FIG. 13C, the grooves Qd are exposed on the surface on the opposite side to change the grooves Qd to the cutting lines Ld. An unnecessary part between the two cutting lines Ld formed in this way is thereafter removed to complete the dividing part Ed (see FIG. 8C). In the step of forming the grooves Qd by the cutting using plasma or laser light (see FIG. 13A), the etched region described in the second modification may be formed instead of the grooves Qd which become the two cutting lines Ld.

### [2-8] Other Modifications

In the above-described method of manufacturing the multilayer device 10, dicing tape may be used as the first support 21 or the second support 22, as appropriate.

The above explanations of the embodiments and the modifications are nothing more than illustrative in any respect, nor should be thought of as restrictive. The scope of the present invention is indicated by claims rather than the above embodiments and modifications. Furthermore, it is intended that all changes that are equivalent to a claim in the sense and realm of the doctrine of equivalence be included within the scope of the present invention.

Some of the steps forming the method of manufacturing the multilayer device 10 may be extracted partially or each of these steps may be extracted individually as a subject of the invention from the above-described embodiments and modifications.

### Reference Signs List

10 Multilayer device
11 Base
12 Chip stack
21 First support
22 Second support
21a, 22a Holding surface
21b, 22b Projection
21c, 22c Contact surface
Ed Dividing part
G1 First joining target
G2 Second joining target
Gb Base parent material
Gc Chip parent material
Ld Cutting line
Mc Chip
Pt Positioning mark
Qd Groove
Rb Base region
Rc Chip region
Wt Predetermined width

## Claims

1. A method of manufacturing a multilayer device, before cutting is performed on a first joining target provided with a plurality of base regions while the first joining target is held by a first support, the cutting being for singulating the base regions individually, the method performing:
a dividing step that performs cutting on a second joining target provided with a plurality of chip regions by means of plasma or laser light while the second joining target is held by a second support to form a dividing part for dividing adjacent ones of the chip regions from each other at a predetermined width therebetween, thereby singulating the chip regions individually; and
a joining step that moves the second support relative to the first support while the first joining target is held by the first support, thereby joining the second joining target to the first joining target in such a manner that at least one of the chip regions corresponding to each of the base regions is stacked on the corresponding base region in a predetermined positional relationship therebetween.

2. The method of manufacturing the multilayer device according to claim 1, wherein
after the joining step, the second support is peeled from the second joining target and a different joining target provided with a plurality of chip regions is further joined to the second joining target,
the first joining target to which the second joining target is joined in the joining step is used as a new first joining target and the different joining target is used as a new second joining target, and then the dividing step and the joining step are further performed for the new first joining target and the new second joining target.

3. The method of manufacturing the multilayer device according to claim 1 or 2, further performing:
a thinning step that thins the second joining target before the dividing step.

4. The method of manufacturing the multilayer device according to any one of claims 1 to 3, wherein
in the dividing step, the dividing part is formed by forming two cutting lines parallel to each other and removing a part between the two cutting lines.

5. The method of manufacturing the multilayer device according to claim 4, wherein
in the dividing step, the two cutting lines are formed in such a manner as to locate a PCM (process control monitor) between the two cutting lines.

6. The method of manufacturing the multilayer device according to any one of claims 1 to 3, wherein
in the dividing step, an etched region etched with plasma and having a predetermined width is formed as the dividing part.

7. The method of manufacturing the multilayer device according to any one of claims 1 to 6, further performing:
an inspecting step that inspects each of the chip regions singulated individually in the dividing step to determine whether the inspected chip region is a defective item, the inspecting step being performed after the dividing step; and
a replacing step that replaces a defective item with a good item if the defective item is detected in the inspecting step, wherein
the joining step is performed after implementation of the replacing step.

8. The method of manufacturing the multilayer device according to any one of claims 1 to 7, wherein
each of the first support and the second support includes a holding sheet containing resin or rubber having at least an attractive force as a main component thereof, and the holding sheet is provided with a plurality of projections formed on a holding surface for holding a corresponding one of the first joining target and the second joining target.

9. The method of manufacturing the multilayer device according to claim 8, wherein
the holding surfaces are provided with the respective projections in such a manner that an area of contact between the second support and the second joining target determined when the second joining target is held by the second support becomes smaller than an area of contact between the first support and the first joining target determined when the first joining target is held by the first support.
